# EUROPEAN PATENT APPLICATION

(11) **EP 4 621 331 A1**
(43) Date of publication of application: **24.09.2025**
(21) Application number: 24218161.8
(22) Date of filing: 06.12.2024
(51) Int. Cl.: F25D 29/00, F25D 23/02, F25D 23/12

(54) **DISPLAY UNIT AND REFRIGERATION APPLIANCE HAVING SAME**

(30) Priority: 29.12.2023 CN 202311866302
(71) Applicant: BSH Hausgeräte GmbH, 81739 München (DE)
(72) Inventor: Huang, Shanshan, Nanjing, 210046 (CN); Zhang, Yong, Nanjing, 210000 (CN)

(57) **Abstract**

Embodiments of the present invention relate to a display unit and a refrigeration appliance having same. The refrigeration appliance includes: a door (2) including a front door panel (211); a dispenser (4), the dispenser including a dispensing cavity (41) located in the door; a mounting portion (20), including a first receiving portion (201) arranged along a side of the dispensing cavity and a second receiving portion (202) in communication with the first receiving portion on a side of the first receiving portion away from the dispensing cavity, the first receiving portion being open towards the front of the door, and the second receiving portion being located behind the front door panel and covered by the front door panel; and a display unit, the display unit including a first part located in the first receiving portion and exposed to the front of the door and a second part located in the second receiving portion and located behind the front door panel.

## Description

### TECHNICAL FIELD

Embodiments of the present invention relate to a display unit and a refrigeration appliance having the display unit.

### BACKGROUND

In a common refrigeration appliance, a display unit is accommodated in a groove, and one side of the display unit is entirely exposed to a position touchable by a user or entirely located behind a glass door panel.

### SUMMARY

One objective of embodiments of the present invention is to provide an improved refrigeration appliance. Another objective of the embodiments of the present invention is to provide an improved display unit.

One aspect of the embodiments of the present invention relates to a refrigeration appliance. The refrigeration appliance includes: a mounting portion and a display unit mounted on the mounting portion. The display unit includes a display portion configured to display information and/or an operation portion configured to receive an operation by a user. The mounting portion includes a first receiving portion recessed along a first direction from a first wall touchable by the user and a second receiving portion in communication with the first receiving portion, recessed along a second direction intersecting with the first direction, and located behind the first wall. The display unit includes a first part located in the first receiving portion and a second part located in the second receiving portion and located behind the first wall. The display portion and/or the operation portion is located in the first part.

In a possible embodiment, the second part includes at least one electronic device or a part of an electronic device; and/or the display unit includes a processor configured to control an electrical component located outside the mounting portion; and/or visible outer surfaces of the display portion and the first wall are flush with each other; and/or the first part includes a plurality of light-emitting elements so as to illuminate the display portion and/or the operation portion.

In a possible embodiment, the processor is at least partially located in the second receiving portion.

In a possible embodiment, the display unit includes a printed circuit board, where the printed circuit board is at least partially located in the second receiving portion; and/or a projection area of the printed circuit board along a direction perpendicular to the printed circuit board is larger than a projection area of the first part along the direction perpendicular to the printed circuit board; and/or the printed circuit board includes a first section located in the first receiving portion and a second section located in the second receiving portion; and/or the display unit includes a support for supporting the printed circuit board, and the support has one part located in the first receiving portion and the other part located in the second receiving portion.

In a possible embodiment, a step is provided between the first part and the second part, the first wall has an end surface exposed to the first receiving portion, and the step and the end surface are arranged face to face.

In a possible embodiment, the display unit includes a support for supporting a printed circuit board and a display panel arranged on one side of the support, where
the display panel covers the first receiving portion, and a part of the support protruding from the display panel in a direction from the first receiving portion to the second receiving portion is located in the second receiving portion; and/or
the display unit includes a touch film located behind the display panel, the touch film is located between the display panel and the support so as to sense a touch operation applied by the user to the operation portion, the printed circuit board is located behind the support, the touch film includes a connection portion, and the connection portion extends from the first part to the second part and is connected to the printed circuit board across the support.

In a possible embodiment, the second part of the display unit is adapted to be inserted into the second receiving portion along a depth direction of the second receiving portion; and/or the second part of the display unit is adapted to be inserted into the second receiving portion along a direction parallel to the first wall.

In a possible embodiment, a first guide mechanism configured to guide the display unit to be inserted into the second receiving portion is provided between the first part and an inner wall of the first receiving portion; and/or a second guide mechanism configured to guide the display unit to be inserted into the second receiving portion is provided between the second part and an inner wall of the second receiving portion.

In a possible embodiment, a first limiting structure configured to limit movement of the first part along at least one direction is provided between the first part and an inner wall of the first receiving portion; and/or a second limiting structure configured to limit movement of the second part along at least one direction is provided between the second part and an inner wall of the second receiving portion.

In a possible embodiment, the refrigeration appliance includes a dispensing cavity configured to receive an external container, and the display unit is arranged along a side of the dispensing cavity.

Another aspect of the embodiments of the present invention relates to a refrigeration appliance. The refrigeration appliance includes: a door including a front door panel; a dispenser, the dispenser including a dispensing cavity located in the door; a mounting portion, including a first receiving portion arranged along a side of the dispensing cavity and a second receiving portion in communication with the first receiving portion on a side of the first receiving portion away from the dispensing cavity, the first receiving portion being open towards the front of the door, and the second receiving portion being located directly behind the front door panel and covered by the front door panel; and a display unit, the display unit including a first part located in the first receiving portion and exposed to the front of the door and a second part located in the second receiving portion and located behind the front door panel.

In a possible embodiment, the display unit includes:
a display panel, the display panel having a display portion and/or an operation portion and being arranged only in the first part of the first part and the second part; and/or
a printed circuit board at least partially located in the second receiving portion; and/or
a support, the support having one part located in the first receiving portion and the other part located in the second receiving portion.

In a possible embodiment, the display unit includes a touch film, and the touch film includes a sensing portion located in the first part and a connection portion extending from the first part to the second part to be connected to the printed circuit board located behind the support; and/or
the printed circuit board has a plurality of light-emitting elements located in the first part; and/or
the display unit includes a connection terminal configured to be connected to a connector located in the door, and the connection terminal is located in the second part; and/or
the support includes a display frame located in the first receiving portion and a hidden frame located in the second receiving portion, a thickness of the display frame is greater than a thickness of the hidden frame, and a step is formed on front surfaces of the display frame and the hidden frame; and/or
along a direction perpendicular to the display panel, a projection area of the support is larger than a projection area of the display panel, and in particular, a ratio of the projection area of the support to the projection area of the display panel ranges from 1.1 to 2; and/or
a thickness of the first part is greater than a thickness of the second part; and/or
a front surface of the first part is substantially flush with a front surface of the door, and a spacing exists between the second part and the front surface of the door.

In a possible embodiment, the first part is adapted to be inserted into the first receiving portion along a direction parallel to a front surface of the display unit; and/or the second part is adapted to be inserted into the second receiving portion along a direction parallel to a front surface of the display unit.

In a possible embodiment, a first guide mechanism configured to guide the display unit to be inserted into the second receiving portion is provided between the first part and an inner wall of the first receiving portion; and/or
a second guide mechanism configured to guide the display unit to be inserted into the second receiving portion is provided between the second part and an inner wall of the second receiving portion.

In a possible embodiment, one of the second part and the inner wall of the second receiving portion is provided with at least one pair of ribs, and a guide groove configured to guide insertion movement of the second part into the second receiving portion is defined between each pair of ribs and/or each pair of ribs is deformable to clamp a column protruding from the other of the second part and the inner wall of the second receiving portion, to prevent the second part from falling off the second receiving portion.

In a possible embodiment, a first limiting structure configured to limit movement of the first part along at least one direction is provided between the first part and an inner wall of the first receiving portion; and/or a second limiting structure configured to limit movement of the second part along at least one direction is provided between the second part and an inner wall of the second receiving portion.

In a possible embodiment, the first limiting structure is configured to limit movement of the first part along a direction perpendicular to the front door panel; and/or the first limiting structure includes a slot located in one of the first part and the inner wall of the first receiving portion and a protruded portion located in the other of the first part and the inner wall of the first receiving portion, the protruded portion being adapted to slide in the slot with relative movement along a direction perpendicular to the front door panel being prevented.

In a possible embodiment, the dispenser includes a dispenser housing, the dispenser housing includes a front face member defining a front boundary of the second receiving portion and located behind the front door panel, and a guide structure configured to guide the second part to be inserted into the second receiving portion and/or a fixing structure configured to fix the second part in the second receiving portion are provided on a rear side of the front face member facing the second receiving portion and a front side of the second part facing the front face member.

In a possible embodiment, the dispenser includes a septum member, and the septum member separates the dispensing cavity from a mounting cavity, where an end of the first part close to the dispensing cavity is supported on the septum member; and/or an insert structure adapted to be inserted along a depth direction of the second receiving portion is provided between the first part and the septum member; and/or the septum member has a limiting structure configured to limit movement of a free end of the first part away from the second part along a direction perpendicular to the front door panel.

Still another aspect of the embodiments of the present invention relates to a display unit. The display unit includes: a display panel; a printed circuit board, including at least one light-emitting element; and a support, the printed circuit board being supported on one side of the support, the display panel being located on the other side of the support, and light emitted by the light-emitting element being adapted to illuminate the display panel through the support, where along a direction perpendicular to the display panel, projection of the display panel is smaller than projection of the support and/or projection of the printed circuit board.

In a possible embodiment, the display unit includes a first part covered by the display panel along the direction perpendicular to the display panel and a second part not covered by the display panel.

In a possible embodiment, the printed circuit board includes a first section located in the first part and a second section located in the second part; and/or
the display unit includes a touch film, and the touch film includes a sensing portion located in the first part and a connection portion extending from the first part to the second part to be connected to the printed circuit board; and/or
the light-emitting element is located in the first part; and/or
the display unit includes a connection terminal configured to be connected to an external connector, and the connection terminal is located in the second part; and/or
a thickness of the first part is greater than a thickness of the second part; and/or
the support includes a display frame located in the first part and a hidden frame located in the second part, a thickness of the display frame is greater than a thickness of the hidden frame, and a step is formed on front surfaces of the display frame and the hidden frame; and/or
along the direction perpendicular to the display panel, a ratio of a projection area of the support to a projection area of the display panel ranges from 1.1 to 2.

The structure of the embodiments of the present invention and other inventive objectives and beneficial effects thereof will become more comprehensible through description of the preferred embodiments with reference to the accompanying drawings.

### BRIEF DESCRIPTION OF THE DRAWINGS

As a part of the specification and intended to provide a further understanding of the present invention, the following accompanying drawings illustrate specific implementations of the present invention, and are used to describe the principle of the present invention together with the specification.
FIG. 1 is a schematic three-dimensional view of a refrigeration appliance according to an embodiment of the present invention;
FIG. 2 is a schematic partial exploded view of a door of the refrigeration appliance according to an embodiment of the present invention;
FIG. 3 is a schematic three-dimensional view of a door of a refrigeration appliance according to another embodiment of the present invention;
FIG. 4 is a schematic partial cross-sectional view along a B-B direction in FIG. 3;
FIG. 5 is a three-dimensional view of a front face member of a dispenser housing according to an embodiment of the present invention;
FIG. 6 is a schematic partial cross-sectional view of a door of a refrigeration appliance according to an embodiment of the present invention;
FIG. 7 is a schematic partial cross-sectional view of a door of a refrigeration appliance with a display unit removed, in which some parts not related to installation of the display unit are removed;
FIG. 8 is a three-dimensional view of a display unit of a refrigeration appliance according to an embodiment of the present invention;
FIG. 9 is an exploded view of a display unit of a refrigeration appliance according to an embodiment of the present invention; and
FIG. 10a to FIG. 10c show an assembly process of a door of a refrigeration appliance according to an embodiment of the present invention.

### DETAILED DESCRIPTION

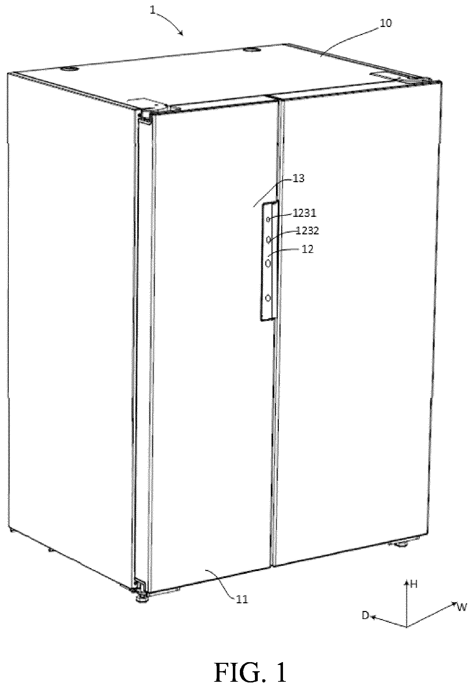

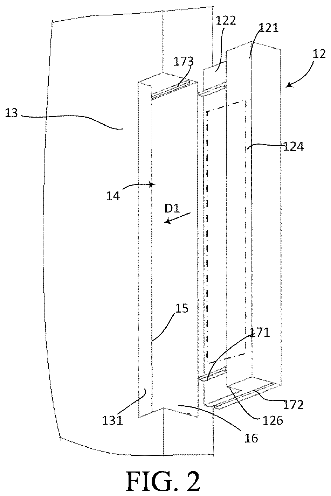

FIG. 1 is a schematic three-dimensional view of a refrigeration appliance 1 according to an embodiment of the present invention. FIG. 2 is a schematic partial exploded view of a door 11 for the refrigeration appliance according to an embodiment of the present invention. As shown in FIG. 1 and FIG. 2, the refrigeration appliance 1 includes an appliance body 10 having a storage compartment (not shown) and the door 11 located in front of the appliance body 10. A user may open or close a corresponding storage compartment in front of the refrigeration appliance 1 by operating different doors.

The refrigeration appliance 1 includes a display unit 12. In this embodiment, the display unit 12 is mounted on the door 11. The door 11 has a mounting portion 14 configured to receive the display unit 12. The mounting portion 14 includes a first receiving portion 16 recessed along a first direction D from a first wall 13 touchable by the user and a second receiving portion 15 in communication with the first receiving portion 16, recessed along a second direction W intersecting with the first direction D, and located behind the first wall 13. The first wall 13 may include a front door panel of the door 11. The first wall 13 may be of a single-layer structure or a composite structure. For example, in some embodiments, the first wall may include the front door panel of the door 11 and another panel body spaced apart from the front door panel or arranged next to the front door panel. In some cases, the first wall 13 may include a heat insulation material located between the front door panel and another panel body located behind the front door panel.

The mounting portion 14 is arranged on a side of the door 11, and the first receiving portion 16 is open towards the side of the door 11. The first receiving portion 16 is recessed backward from the first wall 13 along the thickness direction D (the front-rear direction) of the door 11. The second receiving portion 15 is recessed along a direction away from the side of the door 11.

In an embodiment, the first receiving portion 16 is open towards the front of the door 11 and is recessed backward from the first wall 13.

When the mounting portion 14 is arranged on a longitudinal side, for example, a left side or a right side, of the door 11, the second receiving portion 15 may be recessed along the width direction W (the left-right direction) of the door 11. It should be understood that, if the mounting portion 14 is arranged on a lateral side of the door 11, for example, an upper side or a lower side of the door 11, the second receiving portion 15 may be recessed along a height direction H (a vertical direction) of the door 11. The display unit 12 includes a first part 121 located in the first receiving portion 16 and a second part 122 located in the second receiving portion 15 and located behind the first wall 13. Therefore, the second part 15 is covered by the first wall 13.

The first part 121 includes a display portion 1231 configured to display information to the user and/or an operation portion 1232 configured to receive an input of the user.

At least one electronic device 124 or a part of an electronic device 124 (shown by a dashed box in FIG. 2) is arranged in the second part 122.

The electronic device 124 may include a printed circuit board. The printed circuit board includes a first section located in the first receiving portion 16 and a second section located in the second receiving portion 15.

A step surface 126 is provided between the first part 121 and the second part 122. The step surface 126 and an end surface 131 of the first wall 13 exposed to the first receiving portion 16 are arranged opposite to each other. Visible outer surfaces of the display portion 123 and the first wall 13 may be flush with each other.

The second part 122 of the display unit 12 is adapted to be inserted into the second receiving portion 15 along a depth direction D1 of the second receiving portion 15. In particular, the second part 122 of the display unit 12 is adapted to be inserted into the second receiving portion 15 in a direction parallel to a front surface of the first wall 13.

A guide mechanism configured to guide insertion of the display unit 12 into the second receiving portion 15 is provided between the mounting portion 14 and the display unit 12. The guide mechanism may include guide portions 171, 172, and 173 located in the display unit 12 and/or an inner wall of the second receiving portion 15. The display unit 12 may be inserted into the second receiving portion 15 under the guidance of the guide portions 171, 172, and 173.

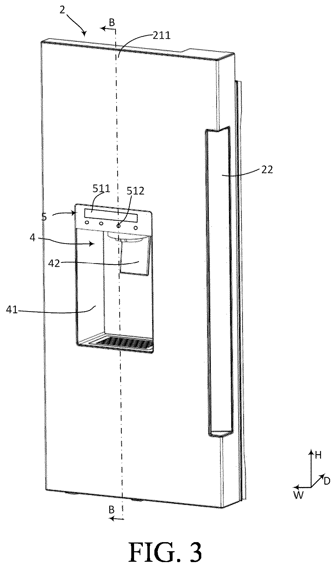

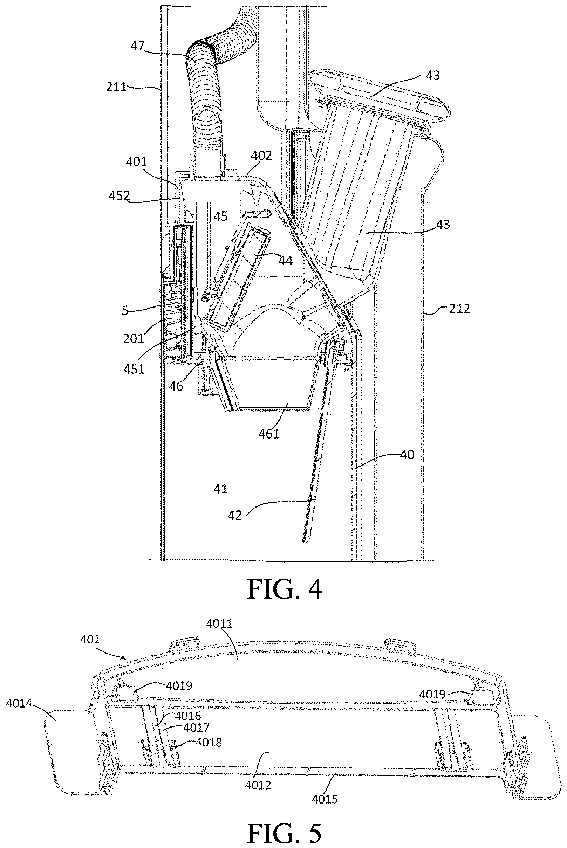

FIG. 3 shows a door 2 used for a refrigeration appliance and having a display unit 2 according to another embodiment of the present invention. FIG. 4 is a schematic cross-sectional view along a B-B direction in FIG. 3.

The door 2 is configured to close a storage compartment (not shown) located in the refrigeration appliance. As shown in FIG. 3 and FIG. 4, the door 2 includes a front door panel 211 and a rear door panel 212 arranged spaced away from each other, and a heat insulation material (not shown) located between the front door panel 211 and the rear door panel 212. In some embodiments, the front door panel 211 forms at least a substantial portion of a front surface of the door 2. Although in the embodiment shown in the figure, the front door panel 211 is of a single-layer structure, it should be understood that the front door panel 211 may alternatively be of a multi-layer structure, including, for example, a metal plate facing the heat insulation material and a decorative plate arranged in front of the metal plate. When the door 2 is in a closed position, the rear door panel 212 faces the storage compartment of the refrigeration appliance.

The door 2 may include a handle groove 22 arranged along a side of the door 2.

The door 2 includes a dispenser 4. The dispenser 4 includes a dispensing cavity 41 for accommodating an external container (not shown). The dispensing cavity 41 is open towards a front side of the door 2 to receive the external container. The dispenser 4 may include a trigger portion 42 located in the dispensing cavity 41. The trigger portion 42 is configured to be operated by a user to trigger the dispensing of ice and/or water.

The dispenser 4 includes a dispenser housing 40 located between the front door panel 211 and the rear door panel 212. An inner side of the dispenser housing 40 may face the heat insulation material of the door 2. The dispensing cavity 41 is located in the dispenser housing 40.

The door 2 includes an ice delivery channel 43 that may be in communication with the storage compartment (not shown) to deliver ice to the dispensing cavity 41.

The dispenser 4 has a dispensing valve 44 configured to open or close the ice delivery channel 43.

A mounting cavity 45 for accommodating components such as the dispensing valve 44 is provided at an upper part of the dispenser housing 40 and above the dispensing cavity 41. The mounting cavity 45 and the dispensing cavity 41 are separated by a septum member 46.

The septum member 46 has an ice outlet channel 461 in communication with the ice delivery channel 43 and the dispensing cavity 41. An edge of the septum member 46 is supported on and fixed to the dispenser housing 40.

The dispenser 4 may further include a water delivery pipe 47. The water delivery pipe 47 passes through the top of the dispenser housing 40, passes through the mounting cavity 45, and passes through the septum member 46 to deliver water into the dispensing cavity 41.

As shown in FIG. 4 and FIG. 5, the dispenser housing 40 includes a front face member 401 arranged above the septum member 46 and along a rear side of the front door panel 211, and a housing body 402 defining and forming most of boundaries defining the dispensing cavity 41 and the mounting cavity 45. The front face member 401 is located in front of the mounting cavity 45 and defines a portion of the boundaries of the mounting cavity 45. In this way, the mounting cavity 45 defined by the dispenser housing 40 includes a lower cavity portion 451 that is open towards the front and an upper cavity portion 452 that is covered by the front face member 401 and the front door panel 211.

The front face member 401 includes a first front face 4011 facing the front door panel 211 and a second front face 4012 located below the first front face 4011. There is a gap between the first front face 4011 and the front door panel 211 to allow the heat insulation material to enter between the first front face 4011 and the front door panel 211. The second front face 4012 is arranged in close contact with a rear surface of the front door panel 211. A storage space for accommodating a heat insulation piece 4013 made of the heat insulation material and independent of the door may be formed between the second front face 4012 and the front door panel 211.

The front face member 401, the front door panel 211, and the heat insulation material located therebetween jointly form a first wall 24 of the door 2 located in front of the mounting cavity 45.

The front face member 401 is connected to the housing body 402 of the dispenser housing 40 at an upper end of the first front face 4011.

The front face member 401 may include a flange 4014 along the rear surface of the front door panel 211. The front face member 401 has a lower edge connected to the front door panel 211 of the door 2, and an upper edge and left and right side edges connected to the housing body 402.

The front face member 401 and the housing body 402 may be manufactured separately and then assembled together, so that a more complex structure may be formed on the front face member 401.

The display unit 5 is arranged along one side of the dispensing cavity 41. The display unit 5 is used by the user to input information to the refrigeration appliance and/or used for displaying information to the user. In the embodiment shown in the figure, the display unit 5 is located above the dispensing cavity 41.

The user may operate the display unit 5 to input an instruction to the dispenser 4. In an embodiment, the user may alternatively set an operating parameter of at least one storage compartment of the refrigeration appliance by operating the display unit 5.

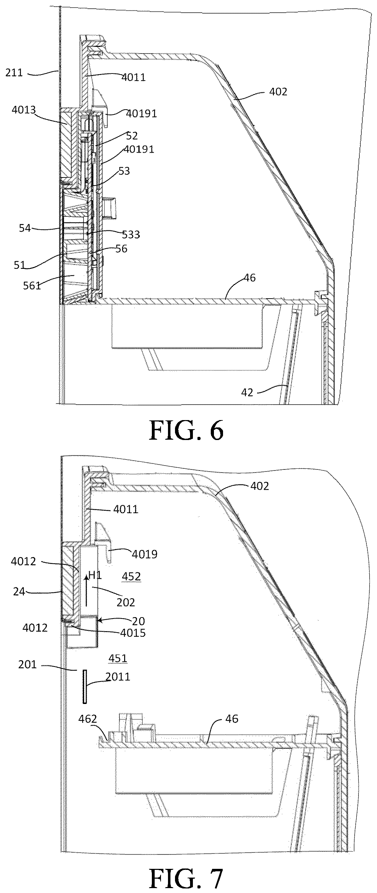

FIG. 6 is a schematic partial cross-sectional view along another cross section of the door shown in FIG. 3. FIG. 7 is a schematic cross-sectional view of the door in FIG. 6 with the display unit 5 removed. To more clearly present a structure of the display unit 5 relative to the dispenser 4, a structure less associated with the mounting of the display unit 5 is removed in FIG. 6 and FIG. 7.

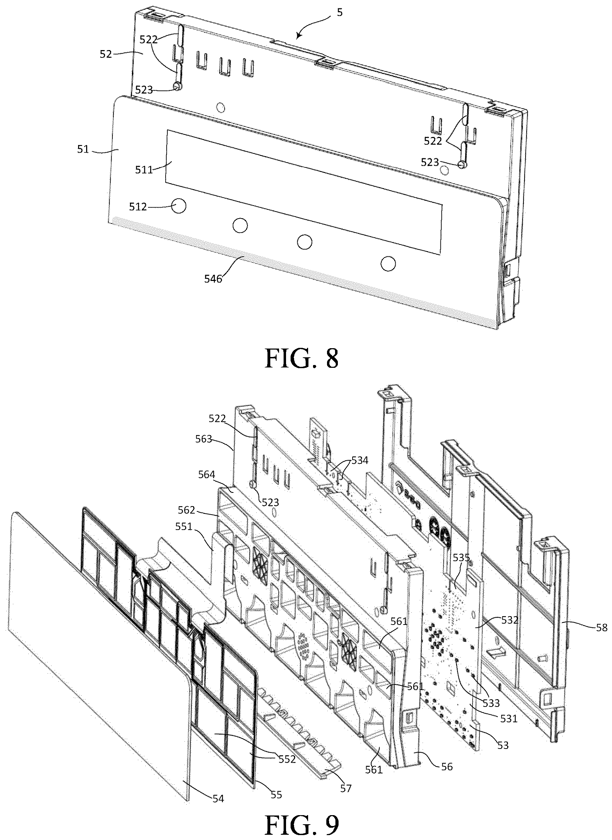

FIG. 8 is a three-dimensional view of the display unit 5 according to an embodiment of the present invention. FIG. 9 is an exploded view of the display unit 5 according to an embodiment of the present invention.

Referring to FIG. 6 to FIG. 9 with reference to FIG. 4, the display unit 5 includes a first part 51 exposed to the front of the door 2 and a second part 52 located behind and shielded by the front door panel 211.

In this way, a part of the display unit 5 exposed to the outside of the door 2 can be constructed more compactly while the display unit 5 can still have a large enough size. When needed, it becomes possible that the display unit 5 may integrate other electronic devices in addition to an electronic device related to interaction with a user. For example, the display unit 5 may have one part of the electronic device located in the first part 51, and another part of the electronic device located in the second part 52.

The door 2 includes a mounting portion 20 for accommodating the display unit 5. The mounting portion 20 includes a first receiving portion 201 configured to receive the first part 51 and a second receiving portion 202 configured to receive the second part 52. The first receiving portion 201 opens towards the front of the door 2 and is exposed to the front of the door 2. The second receiving portion 202 is in communication with the first receiving portion 201, recessed in a direction parallel to the front door panel 21 of the door 2, and located directly behind the front door panel 211.

The mounting portion 20 is arranged along one side of the dispensing cavity 41. In an embodiment, the mounting portion 20 and the display unit 5 are located above the dispensing cavity 41 and arranged along an upper edge of the dispensing cavity 41. In a vertical direction (a height direction of the door), the first receiving portion 51 is located between the septum member 46 and the front face member 401. The second receiving portion 52 is located directly behind the front face member 401. The front face member 401 defines a front boundary of the second receiving portion 52.

The first part 51 has at least one display portion 511 and/or operation portion 512 to display information to the user and/or receive an input from the user, so that the user can operate the display unit 5 and/or obtain information from the display unit 5.

The display unit 5 includes a printed circuit board 53 carrying a plurality of electronic elements. The printed circuit board 53 includes a first section 531 located in the first part 51 and a second section 532 located in the second part 52. Therefore, the printed circuit board 53 continuously extends between the first receiving portion 201 and the second receiving portion 202.

The display unit 5 includes a display panel 54. The display portion 511 and the operation portion 512 are located on the display panel 54.

The display panel 54 may be arranged only in the first part 51 of the first part 51 and the second part 52.

At least most of the projection of the display panel 54 along a thickness direction D of the door 2 is located in the first receiving portion 201. A front surface of the display panel 54 is exposed to the front of the door 2. Therefore, the display portion 511 and the operation portion 512 can be accessed by the user. The front surface of the display panel 54 and a front surface of the front door panel 211 may be substantially flush with each other.

In an embodiment, the display panel 54 may include a transparent substrate and an opaque layer attached to the transparent substrate. A light source of the printed circuit board 53 passes through a corresponding region of the display panel 54 to display information to the user. The projection of the display panel 54 along the thickness direction D of the door 2 covers the first section 531 of the printed circuit board 53. The projection of the display panel 54 along the thickness direction D of the door 2 does not overlap with the second section 532 of the printed circuit board 53.

As shown in FIG. 9, the display unit 5 includes a support 56, and the printed circuit board 53 is supported on the support 56. The support 56 has a larger size than the display panel 5. Therefore, a part of the support 56 corresponding to the second section 532 is located outside projection of the display panel 5 on the support 56.

The display unit 5 may include a touch film 55 located behind the display panel 54. The touch film 55 is sandwiched between the display panel 54 and the support 56. The printed circuit board 53 is arranged behind the support 56. The touch film 55 includes a sensing portion 552 located in the first part 51 and a connection portion 551 extending from the first part 51 to the second part 52 to be connected to the printed circuit board 53 located behind the support 56.

The printed circuit board 53 has a plurality of light-emitting elements 533 in a region corresponding to the display panel 54. Correspondingly, the support 56 has a plurality of through holes 561 to allow light emitted by the light-emitting element 533 to illuminate the touch film 55 and the display panel 54. In this way, the display unit 5 may display/indicate information to the user, including but not limited to displaying/indicating a position and/or a meaning of a touch region of the display panel 54.

The printed circuit board 53 may include a first processor (not shown) configured to process user interaction information.

The first processor is separately connected to the touch film 55 and the light emitting element 533 to receive an input from the touch film 55 and output an instruction to the corresponding light emitting element 533.

The printed circuit board 53 may further include a second processor. The second processor may be configured, for example, to control an electrical component located outside the mounting portion 20, for example, an electrical component of a chilling water system in the refrigeration appliance.

In an embodiment, the first processor may be located in the first part 51 of the display unit 5, and the second processor may be located in the second part 52. In this way, the interference of the second processor and its related electronic elements to the display region and the operation region can be reduced.

Other processors and/or circuits, in addition to input and output signals related to user interaction of the refrigeration appliance, are integrated into the display unit 5. Therefore, such electronic devices may not need to be additionally arranged in other parts of the refrigeration appliance. This helps improve the integration of electronic components.

A front surface of the first part 51 of the display unit 5 protrudes forwardly from a front surface of the second part 52. In particular, the first part 51 has a greater thickness than the second part 52. Therefore, there is a step between the first part 51 and the second part 52. When the front surface of the first part 51 is substantially flush with a front surface of the door 2, the front surface of the second part 52 and the front surface of the door 2 are spaced apart from each other in the thickness direction of the door 2.

Along a direction perpendicular to the display panel 54, a projection area of the support 56 is larger than a projection area of the display panel 54. A ratio of the projection area of the support 56 to the projection area of the display panel 54 may range from 1.1 to 2.

The support 56 includes a display frame 562 corresponding to the display panel 54 and a hidden frame 563 located directly behind the front door panel 211. The display frame 562 protrudes more forwardly than the hidden frame 563, and forms a step surface 564 connecting the first part 51 and the second part 52 on the front side of the support 56. The through hole 561 is located in the display frame 562. The hidden frame 563 covers the second section 532 of the printed circuit board 53.

As shown in FIG. 6, in the mounting position, the step surface 564 is arranged face-to-face with an end surface 4015 of the front face member 401 exposed to the first receiving portion 201, and therefore is also face-to-face with an end surface of the first wall 24 exposed to the first receiving portion 201. An upper end of the display panel 54 may extend towards an end of the flexible connection portion 551, whose front side is covered by the touch film 55 of the front face member 401, away from the display frame 562 and facing the hidden frame 563, and span the hidden frame 563 and extend to the rear side of the hidden frame 563 to be connected to the printed circuit board 53.

The display unit 5 may include a light guide module 57 arranged along an edge of the display unit 5. The light guide module 57 is configured to guide light of the corresponding light-emitting element 533 to the edge of the display panel 54.

A lower edge of the light guide module 57 may be flush with an outer contour line of the display panel 54 viewed from the front, so that an illuminated region having no gap away from at least part of the outer contour line of the display panel 54 can be obtained on the display panel 54. FIG. 8 schematically shows such an illuminated strip region 546.

The display unit 5 may include a rear cover 58 to cover a rear side of the printed circuit board 53. This helps prevent liquid of the chilling water system from accidentally coming in contact with the electronic device of the display unit 5.

The display unit 5 includes connection terminals 534 and 535 configured to be connected to an external connector (not shown). The connection terminals 534 and 535 are located in the second part 52. The connection terminals 534 and 535 may be integrated on an edge of the printed circuit board 53 away from the first part.

The second part 52 of the display unit 5 is adapted to be inserted into the second receiving portion 202 along a depth direction H1 of the second receiving portion 202. In particular, the second part 52 of the display unit 5 is adapted to be inserted into the second receiving portion 202 along a direction parallel to the front surface of the front door panel 211. In this embodiment, the depth direction H1 of the second receiving portion 202 extends from bottom to top along a height direction of the door 2.

The door 2 may include a guide mechanism configured to guide the display unit 12 to be inserted into the second receiving portion 15. The guide mechanism may be located in the display unit 5 and/or an inner wall facing the second receiving portion 202, and in particular, located between the display unit 5 and the dispenser housing 40.

In some embodiments, at least one first guide mechanism is located between the first part 51 of the display unit 5 and an inner wall of the first receiving portion 201. For example, the first guide mechanism is located on left and right sides of the first part 51 and on a part of the dispensing cavity housing 40 corresponding to the first receiving portion 201.

In some embodiments, at least one second guide mechanism is located between the second part 52 of the display unit 5 and an inner wall of the second receiving portion 202. For example, the second guide mechanism is located between a front side of the second part 52 and the inner wall facing the second receiving portion 202.

In some embodiments, the guide mechanism may include the first guide mechanism and the second guide mechanism, so that both the first part 51 and the second part 52 can be guided during the sliding insertion of the display unit 5 into the second receiving portion 202.

In some embodiments, the guide mechanism may include a guide groove located in one of the display unit 5 and the dispenser housing 40 and a protrusion located in the other of the display unit 5 and the dispenser housing 40 to guide sliding of the display unit 5.

The display panel 54 may be wider than the remaining part of the display unit 5, and in particular, wider than the support 56, so that the left and right sides of the display panel 54 exceed the support 56. The two sides of the display panel 54 cover left and right edges of the dispensing cavity 41.

During assembly, the two sides of the display panel 54 may be placed on the two sides of the dispensing cavity 41, and in particular, a front edge of the dispenser housing 40 in the dispensing cavity 41. An inner side of the display panel 54 slides upward along the dispenser housing 40 until the second part 52 slides upward into the second receiving portion 202 located in the upper cavity portion 452.

In some embodiments, a first limiting structure configured to limit movement of the first part 51 along at least one direction is provided between the first part 51 and an inner wall of the first receiving portion 201.

In some embodiments, a second limiting structure configured to limit movement of the second part 52 along at least one direction is provided between the second part 52 and an inner wall of the second receiving portion 202.

Movement of the second part 52 of the display unit 5 directly behind the front door panel 211 along the thickness direction D and a width direction W of the door 2 may be limited, to prevent the second part 52 of the display unit 5 from swaying in the thickness direction D and the width direction W of the door 2.

Through the guide mechanism between the display unit 6 and the door body, after the display unit 5 is slid in place, the second part 52 of the display unit 5 can be limited directly behind the front door panel 211 in at least one of the thickness direction D, the width direction W, and a height direction H of the door 2.

As shown in FIG. 5 and FIG. 8, the front face member 401 has a guide groove 4016 on an inner side facing the second receiving portion 202. Correspondingly, a front side of the second part 52 of the display unit 5 is provided with a guide rail 522 protruding forwardly. The guide rail 522 may be arranged on a front side of the hidden frame 563.

A lower end of the guide groove 4016 is open. Therefore, when the display unit 5 slides toward the depth direction H1 of the second receiving portion 202, the guide rail 522 may enter the guide groove 4016 and slide along the guide groove 4016.

A width of the guide groove 4016 at an entrance is greater than a width of the guide rail 522, allowing the guide rail 522 to smoothly slide into the guide groove 4016. After being mounted in place, movement of the guide rail 522 in at least the width direction W of the door 2 is limited by an inner wall of the guide groove 4016. The guide rail 522 is in contact with the inner wall of the guide groove 4016 in the width direction W (the left-right direction) of the door 2 to prevent the guide rail 522 from swaying in the width direction W of the door 2.

The guide groove 4016 may be located between a pair of ribs 4017 protruding from a rear surface of the second front face 4012.

The guide rail 522 is sandwiched between the ribs 4017 in the width direction W of the door 2. In this way, the movement of the guide rail 522 in the width direction W of the door 2 and the thickness direction of the door 2 is limited.

The front face member 401 may include a limiting portion 4019 extending into the mounting cavity 45 to define an upper boundary of the second receiving portion 202. When the display unit 5 slides to come in contact with the limiting portion 4019, further sliding of the display unit 5 is prevented, and the display unit 5 is mounted in place.

The limiting portion 4019 may be constructed as an L-shaped tongue piece. Therefore, the limiting portion 4019 includes a limiting piece 40191 extending along a direction parallel to the front door panel 211. The limiting piece 40191 may limit a top end of the display unit 5 from moving backward, especially from flipping backward.

In an exemplary embodiment, the second part 52 of the display unit 5 is also limited in the height direction H of the door 2 to prevent the display unit 52 from falling downward from the door 2.

The front face member 401 has a dent 4018 recessed in a direction away from the second receiving portion 202 at a position corresponding to lower ends of a pair of ribs 4017, so that the ribs 4017 are in a suspended state and elastic at the position corresponding to the dent 4018. In this way, a deformable clamping portion may be formed between the ribs 4017 at the position corresponding to the dent 4018.

The display unit 5 includes a column 523 adapted to be clamped between a pair of ribs 4017. The column 523 has a width greater than that of the guide rail 522 and is located below the guide rail 522. During the insertion of the display unit 5 into the second receiving portion 202, the column 523 enters the guide groove 4016 later than the guide rail 522.

In a natural state, a size of the column 523 along a width direction W of the front face member 401 is greater than a width of a clamping portion formed between a pair of ribs 4017. After the column 523 enters the guide groove 4016, parts of the ribs 4017 corresponding to the dent 4018 expand in a direction away from each other due to extrusion of the column 523, allowing the column 523 to be clamped.

The rib 4017 may have a shape corresponding to that of an outer peripheral surface of the column 523 at a position corresponding to the column 523. In this embodiment, the column 523 is a cylinder, and each rib 4017 has an arc-shaped recess on the inner side clamping the column 523, so that movement of the column 523 in a sliding direction of the second receiving portion 202 is further limited. In this way, the display unit 5 may be hooked to the inner wall of the second receiving portion 202.

In an embodiment, when a downward tension force applied to the display unit 5 is not greater than 20-40 N (for example, 30 N), the display unit 5 does not fall off the door 2 because the column 523 is clamped by the ribs 4017.

In this way, in the process in which the display unit 5 is guided to slide into the second receiving portion 202, the display unit 5 can be reliably guided, and after the display unit 5 moves into place, swaying of the second part 52 of the display unit 5 located behind the front door panel 211 in the width direction W of the door 2, the thickness direction D of the door 2, and the height direction H of the door can be limited by using the structure located in the second receiving portion 202.

The door 2 includes a fixing structure configured to fix the first part 52 of the display unit 5. In an embodiment, a lower end of the display unit 5 is supported by the septum member 46.

A front end of the septum member 46 is pluggably connected to the first part 51 of the display unit 5 along a vertical direction, that is, the height direction H of the door 2. At least one of the septum member 46 and the first part 51 has a slot to receive an insert portion of the other, to form an insert structure of the septum member 46 and the first part 51. In this way, after the septum member 46 is fixed to the dispenser housing 40, an free end of the first part 51 away from the second part 52 may be further supported, and the septum member 46 and the first part 51 may be inserted and fitted to prevent a free end of the display unit 5 away from the second part 52 from swaying in the thickness direction D.

In the embodiment shown in FIG. 6 and FIG. 7, the septum member 46 has a slot 462 to receive a lower end of the first part 51, thereby reducing a possibility of swaying of the first part 51.

In an embodiment, a second limiting mechanism for preventing the first part 51 from swaying in the thickness direction D of the door 2 may be further provided between the inner wall of the first receiving portion 201 and the two sides of the first part 51 of the display unit 5. For example, as shown in FIG. 7, a slot 2011 or a protruded portion extending along the height direction H of the door 2 may be provided in the inner wall of the first receiving portion 201. The first part 51 of the display unit 5 may be provided with a protruded portion or a groove (not shown) adapted to slide along the slot 2011, and shapes and sizes of the protruded portion and the slot 2011 are designed to prevent the first part 51 from swaying in the thickness direction D of the door 2. It should be understood that other structures may alternatively be used between the first receiving portion 201 and the two sides of the first part 51 to prevent the first part 51 from swaying in the thickness direction D of the door 2.

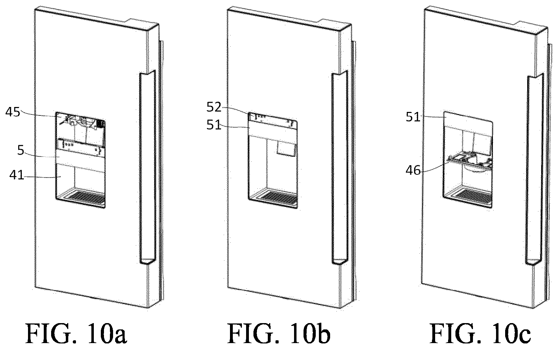

During manufacturing, as shown in FIG. 10a, two ends of the display panel 54 of the display unit 5 are first placed on the two sides of the dispensing cavity 41. Because the display panel 54 is wider than the rest of the display unit 5, the support 56 located behind the display panel 54 may completely fall into the dispensing cavity 41 or the mounting cavity 45 without interference.

Before the display unit 5 is moved, the display unit 5 may be first connected to an electrical connector located on the door 2. In this embodiment, the second part 52 of the display unit 5 is provided with connection terminals 534 and 535 configured to be connected to a door-end connector (not shown). The connection terminals 534 and 535 are accessible from an end of the second part 52 away from the first part 51. The connection terminals 534 and 535 may be integrated into the printed circuit board 53.

Then, as shown in FIG. 10b, the display unit 5 is pushed toward the second receiving portion 202 along a direction parallel to the front door panel 211. Specifically, the second part 52 of the display unit 5 slides towards the second receiving portion 202 located in the mounting cavity 45. The guide rail 522 enters the guide groove 4016 whose lower end is open and slides upward along the guide groove 4016 until the step surface 564 between the first part 51 and the second part 52 abuts against a lower end of the front face member 401.

The display unit 5 is positioned by a fixing device located on the second part 52 and the inner wall of the second receiving part 202. After the display unit 5 is in place, the terminals 534 and 535 are located in the second receiving portion 202.

Then, as shown in FIG. 10c, the septum member 46 is assembled. Specifically, the septum member 46 is pushed from bottom to top towards a mounting position of the dispenser housing 40. The front end of the septum member 46 may be connected to and support the lower end of the display unit 5.

The front end of the septum member 46 may be pluggably connected to the lower end of the display unit 5 during the mounting the septum member 46 into the dispenser housing 40. In particular, the lower end of the display unit 5 is inserted into the slot 462, so that the lower end of the display unit 5 can be supported. In this way, the display unit 5 and the septum member 46 are assembled on the door 2.

In the foregoing embodiment, the display unit 5 is located above the dispensing cavity. It should be understood that the principle of the present invention is also applicable to a case in which the display unit is arranged on a left side or a right side of the dispensing cavity.

In the foregoing embodiment, the display unit 12, 5 is arranged on the door. It should be understood that the principle of the present invention is also applicable to a case in which the display unit is arranged at another position of the refrigeration appliance, for example, the body of the refrigeration appliance.

Various embodiments of single parts and components described with reference to FIG. 1 to FIG. 10c may be combined with each other in any given manner to achieve the advantages of the present invention. In addition, the present invention is not limited to the shown embodiments, and generally, other means than the shown means may also be used, provided that the means can also achieve the same effect.

## Claims

1. A refrigeration appliance, comprising:
a mounting portion (14, 20) and a display unit (12, 5) mounted on the mounting portion, the display unit comprising a display portion configured to display information and/or an operation portion configured to receive an operation by a user, the mounting portion comprising a first receiving portion (16, 201) recessed along a first direction (D) from a first wall (13, 24) touchable by the user and a second receiving portion (15, 202) in communication with the first receiving portion, recessed along a second direction (W) intersecting with the first direction, and located behind the first wall, the display unit comprising a first part (121, 51) located in the first receiving portion and a second part (122, 52) located in the second receiving portion and located behind the first wall, and the display portion and/or the operation portion being located in the first part.

2. The refrigeration appliance according to claim 1, **characterized in that**
the second part comprises at least one electronic device or a part of an electronic device; and/or
the display unit comprises a processor configured to control an electrical component located outside the mounting portion; and/or
visible outer surfaces of the display portion and the first wall are flush with each other; and/or
the first part comprises a plurality of light-emitting elements so as to illuminate the display portion and/or the operation portion.

3. The refrigeration appliance according to claim 2, **characterized in that** the processor is at least partially located in the second receiving portion.

4. The refrigeration appliance according to one or more of claims 1 to 3, **characterized in that** the display unit comprises a printed circuit board, wherein
the printed circuit board is at least partially located in the second receiving portion; and/or
a projection area of the printed circuit board along a direction perpendicular to the printed circuit board is larger than a projection area of the first part along the direction perpendicular to the printed circuit board; and/or
the printed circuit board comprises a first section located in the first receiving portion and a second section located in the second receiving portion; and/or
the display unit comprises a support for supporting the printed circuit board, and the support has one part located in the first receiving portion and the other part located in the second receiving portion; and/or
a step is provided between the first part and the second part, the first wall has an end surface exposed to the first receiving portion, and the step and the end surface are arranged face to face; and/or
the display unit comprises a support for supporting a printed circuit board and a display panel arranged on one side of the support, wherein
the display panel covers the first receiving portion, and a part of the support protruding from the display panel in a direction from the first receiving portion to the second receiving portion is located in the second receiving portion; and/or
the display unit comprises a touch film located behind the display panel, the touch film is located between the display panel and the support so as to sense a touch operation applied by the user to the operation portion, the printed circuit board is located behind the support, the touch film comprises a connection portion, and the connection portion extends from the first part to the second part and is connected to the printed circuit board across the support; and/or
the second part of the display unit is adapted to be inserted into the second receiving portion along a depth direction of the second receiving portion; and/or
the second part of the display unit is adapted to be inserted into the second receiving portion along a direction parallel to the first wall; and/or
a first guide mechanism configured to guide the display unit to be inserted into the second receiving portion is provided between the first part and an inner wall of the first receiving portion; and/or
a second guide mechanism configured to guide the display unit to be inserted into the second receiving portion is provided between the second part and an inner wall of the second receiving portion; and/or
a first limiting structure configured to limit movement of the first part along at least one direction is provided between the first part and an inner wall of the first receiving portion; and/or
a second limiting structure configured to limit movement of the second part along at least one direction is provided between the second part and an inner wall of the second receiving portion; and/or
the refrigeration appliance comprises a dispensing cavity configured to receive an external container, and the display unit is arranged along a side of the dispensing cavity.

5. A refrigeration appliance, **characterized in that** the refrigeration appliance comprises:
a door (2) comprising a front door panel (211);
a dispenser (4), the dispenser comprising a dispensing cavity (41) located in the door;
a mounting portion (20), comprising a first receiving portion (201) arranged along a side of the dispensing cavity and a second receiving portion (202) in communication with the first receiving portion on a side of the first receiving portion away from the dispensing cavity, the first receiving portion being open towards the front of the door, and the second receiving portion being located behind the front door panel and covered by the front door panel; and
a display unit, the display unit comprising a first part located in the first receiving portion and exposed to the front of the door and a second part located in the second receiving portion and located behind the front door panel.

6. The refrigeration appliance according to claim 5, **characterized in that** the display unit comprises:
a display panel, the display panel having a display portion and/or an operation portion and being arranged only in the first part of the first part and the second part; and/or
a printed circuit board at least partially located in the second receiving portion; and/or
a support, the support having one part located in the first receiving portion and the other part located in the second receiving portion.

7. The refrigeration appliance according to claim 6, **characterized in that**
the display unit comprises a touch film, and the touch film comprises a sensing portion located in the first part and a connection portion extending from the first part to the second part to be connected to the printed circuit board located behind the support; and/or the printed circuit board has a plurality of light-emitting elements located in the first part; and/or
the display unit comprises a connection terminal configured to be connected to a connector located in the door, and the connection terminal is located in the second part; and/or
the support comprises a display frame located in the first receiving portion and a hidden frame located in the second receiving portion, a thickness of the display frame is greater than a thickness of the hidden frame, and a step is formed on front surfaces of the display frame and the hidden frame; and/or
along a direction perpendicular to the display panel, a projection area of the support is larger than a projection area of the display panel, and in particular, a ratio of the projection area of the support to the projection area of the display panel ranges from 1.1 to 2; and/or
a thickness of the first part is greater than a thickness of the second part; and/or
a front surface of the first part is substantially flush with a front surface of the door, and a spacing exists between the second part and the front surface of the door.

8. The refrigeration appliance according to one or more of claims 5 to 7, **characterized in that**
the first part is adapted to be inserted into the first receiving portion along a direction parallel to a front surface of the display unit; and/or the second part is adapted to be inserted into the second receiving portion along a direction parallel to a front surface of the display unit.

9. The refrigeration appliance according to one or more of claims 5 to 8, **characterized in that**
a first guide mechanism configured to guide the display unit to be inserted into the second receiving portion is provided between the first part and an inner wall of the first receiving portion; and/or
a second guide mechanism configured to guide the display unit to be inserted into the second receiving portion is provided between the second part and an inner wall of the second receiving portion.

10. The refrigeration appliance according to claim 9, **characterized in that**
one of the second part and the inner wall of the second receiving portion is provided with at least one pair of ribs, and a guide groove configured to guide insertion movement of the second part into the second receiving portion is defined between each pair of ribs and/or each pair of ribs is deformable to clamp a column protruding from the other of the second part and the inner wall of the second receiving portion, to prevent the second part from falling off the second receiving portion.

11. The refrigeration appliance according to claim 7, **characterized in that**
a first limiting structure configured to limit movement of the first part along at least one direction is provided between the first part and an inner wall of the first receiving portion; and/or
a second limiting structure configured to limit movement of the second part along at least one direction is provided between the second part and an inner wall of the second receiving portion.

12. The refrigeration appliance according to claim 11, **characterized in that**
the first limiting structure is adapted to limit movement of the first part along a direction perpendicular to the front door panel; and/or the first limiting structure comprises a slot located in one of the first part and the inner wall of the first receiving portion and a protruded portion located in the other of the first part and the inner wall of the first receiving portion, the protruded portion being adapted to slide in the slot with relative movement along a direction perpendicular to the front door panel being prevented.

13. The refrigeration appliance according to claim 7, **characterized in that**
the dispenser comprises a dispenser housing, the dispenser housing comprises a front face member defining a front boundary of the second receiving portion and located behind the front door panel, and a guide structure configured to guide the second part to be inserted into the second receiving portion and/or a fixing structure configured to fix the second part in the second receiving portion are provided on a rear side of the front face member facing the second receiving portion and a front side of the second part facing the front face member; and/or
the dispenser comprises a septum member, and the septum member separates the dispensing cavity from a mounting cavity, wherein an end of the first part close to the dispensing cavity is supported on the septum member; and/or
an insert structure adapted to be inserted along a depth direction of the second receiving portion is provided between the first part and the septum member; and/or
the septum member has a limiting structure configured to limit movement of a free end of the first part away from the second part along a direction perpendicular to the front door panel.

14. A display unit, **characterized by** comprising:
a display panel;
a printed circuit board, comprising at least one light-emitting element; and
a support, the printed circuit board being supported on one side of the support, the display panel being located on the other side of the support, and light emitted by the light-emitting element being adapted to illuminate the display panel through the support, wherein
along a direction perpendicular to the display panel, projection of the display panel is smaller than projection of the support and/or projection of the printed circuit board.

15. The display unit according to claim 14, **characterized in that**
the display unit comprises a first part covered by the display panel along the direction perpendicular to the display panel and a second part not covered by the display panel, wherein
the printed circuit board comprises a first section located in the first part and a second section located in the second part; and/or
the display unit comprises a touch film, and the touch film comprises a sensing portion located in the first part and a connection portion extending from the first part to the second part to be connected to the printed circuit board; and/or
the light-emitting element is located in the first part; and/or
the display unit comprises a connection terminal configured to be connected to an external connector, and the connection terminal is located in the second part; and/or
a thickness of the first part is greater than a thickness of the second part; and/or
the support comprises a display frame located in the first part and a hidden frame located in the second part, a thickness of the display frame is greater than a thickness of the hidden frame, and a step is formed on front surfaces of the display frame and the hidden frame; and/or
along the direction perpendicular to the display panel, a ratio of a projection area of the support to a projection area of the display panel ranges from 1.1 to 2.
